# EUROPEAN PATENT SPECIFICATION

(11) **EP 1 898 257 B1**
(45) Date of publication and mention of the grant of the patent: **06.10.2010**
(21) Application number: 07253457.1
(22) Date of filing: 31.08.2007
(51) Int. Cl.: G02F 1/1368

(54) **Liquid crystal display panel and method for manufacturing the same**
Flüssigkristallanzeigetafel und Herstellungsverfahren dafür
Panneau d'affichage à cristaux liquides et procédé de fabrication de ce dernier

(30) Priority: 05.09.2006 JP 2006239799
(43) Date of publication of application: 12.03.2008
(73) Proprietor: Future Vision Inc., Tokyo 107-0052 (JP)
(72) Inventor: Yoshimoto, Yoshikazu, Tokyo 107-0052 (JP)
(74) Representative: Calderbank, Thomas Roger

(56) References cited:
- JP-A- 2003 318 193
- US-A1- 2006 086 978
- US-B1- 6 956 236

## Description

The present invention relates to a liquid crystal display system. In particular, the invention relates to an active matrix type liquid crystal display panel and a method for manufacturing the same.

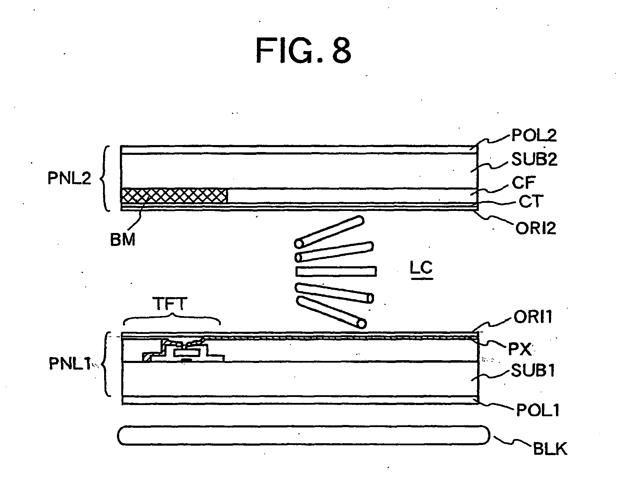

A liquid crystal display panel system of this type comprises a liquid crystal display panel PNL and a combination of a driving circuit and peripheral devices such as backlight. Fig. 8 is a schematical cross-sectional view to explain an example of approximate arrangement of a typical longitudinal electric field type (the so-called TN type) liquid crystal display system. Normally, a liquid crystal display panel, which makes up an active matrix type liquid crystal display system, is prepared by sealing a liquid crystal LC between a first panel PNL1 comprising a first substrate (an active matrix substrate or a thin-film transistor substrate) and a second substrate (a counter substrate or a color filter substrate).

On inner surface of the first substrate SUB1, which makes up the first panel PNL1, there are provided a thin-film transistor TFT and a pixel electrode PX driven by the thin-film transistor TFT. On the uppermost layer, a first orientation film ORI1 is deposited, and it is provided with an ability to control liquid crystal orientation. On outer surface (back surface), a first polarizing plate POL1 is attached. On the other hand, a color filter CF, a light-shielding layer (black matrix) BM to partition off from the color filter of adjacent pixel, and a counter electrode CT are arranged on inner surface of the second substrate SUB2, which makes up a second panel PNL2. On the uppermost layer, a second orientation film ORI2 is deposited, which is provided with an ability to control liquid crystal orientation. On outer surface (front surface), a second polarizing plate POL2 is attached, which has a polarization axis positioned in crossed Nicols arrangement to the polarization axis of the first polarizing plate POL1. Detailed arrangement is not shown in the figure.

In the manufacturing process to prepare the thin-film transistor TFT on the first substrate SUB1, a plurality of gate lines in parallel arrangement and made of metal film such as chromium and gate electrodes extending from the gate lines for each pixel are formed on the substrate. Then, an insulating layer, an active layer (silicon semiconductor layer), a data line, a drain electrode (source-drain electrode), a pixel electrode, a protective film, an orientation film, etc. are prepared. The orientation film is provided with an ability to control liquid crystal orientation, and the first substrate is thus formed. On the back surface of the first substrate SUB1, a backlight BLK is mounted. A circuit to drive this liquid crystal display panel is not shown in the figure. The source electrode and the drain electrode are switched over to each other during operation. Description will be given by referring the electrode extending from the data line as the drain electrode, and by referring the electrode connected to the pixel electrode as the source electrode.

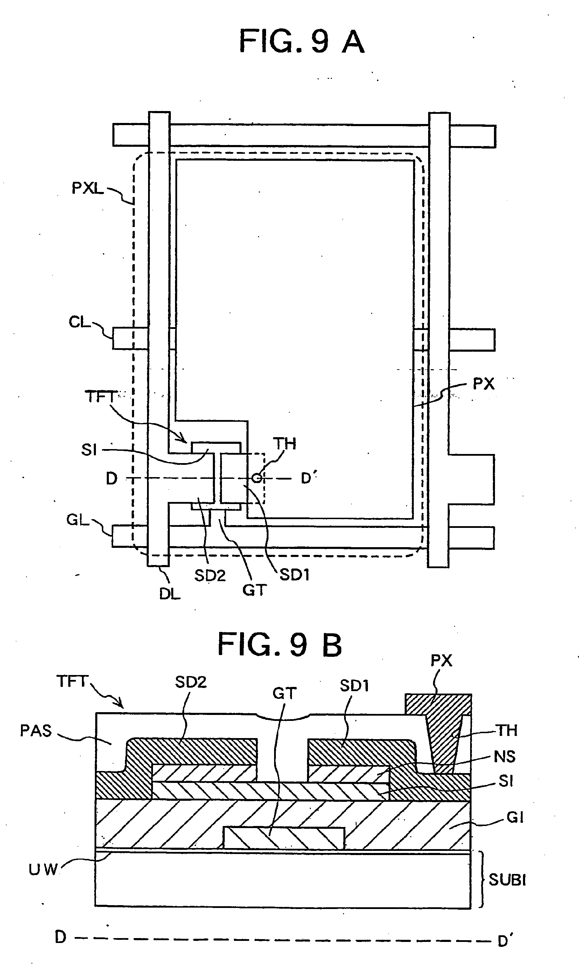

Fig. 9 represents drawings to explain an arrangement of a pixel of the liquid crystal display panel as shown in Fig. 8 and an arrangement of the thin-film transistor, which makes up the pixel. Specifically, Fig. 9 (a) is a plan view of the pixel, and Fig. 9 (b) is a cross-sectional view along the line D-D' in Fig. 9 (a). As shown in Fig. 9 (a), a pixel is disposed on an intersection of the gate line GL and the data line DL on the thin-film transistor TFT. The pixel electrode, which constitutes the pixel, is connected to the source electrode SD1 of the thin-film transistor TFT via a contact hole TH. Also, an auxiliary capacity is provided between an auxiliary capacity line CL and the pixel electrode.

In Fig. 9 (b), the gate electrode GT extending from the gate line GL and the gate insulator film GI to cover the gate electrode GT are prepared on the underlying layer UW on the surface of the first substrate SUB1 of the thin-film transistor TFT. On this gate insulator film GI, a silicon (Si) semiconductor layer SI as an active layer, an ohmic contact layer (n⁺ Si) NS, a source electrode SD1 and a drain electrode SD2 are sequentially laminated. The underlying layer UW is formed by a laminated film of silicon nitride and silicon oxide.

On the gate line GL and the gate electrode GT, a gate insulator film GI preferably made of silicon nitride (SiNx) is deposited, and a plurality of data lines DLs perpendicularly crossing the gate lines GLs are formed on it. At the same time with the formation of the data lines DLs, the source electrode SD1 and the drain electrode SD2 are prepared on the same layer.

In case of full-color display, this pixel is a subpixel each with a single color (red, green or blue). Here, it is simply referred as a pixel. The thin-film transistor, which makes up the pixel, comprises the gate electrode GT, a silicon semiconductor film SI prepared on the gate electrode by patterning, ohmic contact layers (n⁺ silicon) NS formed separately on upper layer of the silicon semiconductor film, and a source electrode and a drain electrode connected respectively to each of the separated ohmic contact layers.

On upper layer of the thin-film transistor, a protective film PAS is prepared. On it, the pixel electrode PX preferably made of ITO is placed by patterning, and it is connected to the source electrode SD1 via a contact hole TH formed on the protective film PAS. A first orientation film (see Fig. 8) is deposited to cover the pixel electrode PX and the protective film PAS, but it is not shown in the figure.

On the other hand, a counter electrode (see Fig. 8) is formed via a 3-color color filter (in case of full-color display) and a smooth layer (over-coating layer; not shown in Fig. 8) is prepared on the other substrate not shown in the figure. A second orientation film (see Fig. 8) is deposited to cover the counter electrode. This is superimposed on the active matrix substrate, which is the other substrate as described above, and the liquid crystal is sealed in the gap.

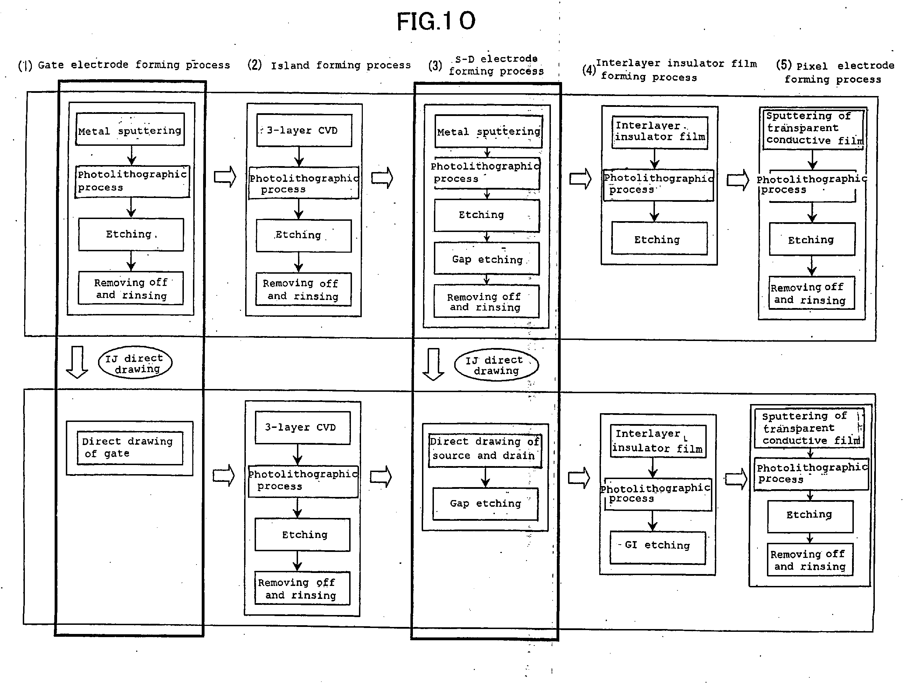

Fig. 10 represents process charts to compare the number of processes in the method for manufacturing the thin-film transistor of the first panel PNL1 between the conventional photolithographic method and the ink jet direct drawing method to prepare the gate electrode, the source electrode and the drain electrode (source-drain electrodes). The upper portion of Fig. 10 represents processes to prepare the thin-film transistor by the conventional photolithographic process, and the lower portion represents the processes by introducing the ink jet direct drawing method to lines and electrodes of the thin-film transistor. Description will be given below sequentially on each of the processes shown in the upper portion of the figure.

### (1) Gate electrode forming process of the thin-film transistor

On (the underlying film of) the thin-film transistor substrate, a thin-film of a metal to be turned to the gate electrode is deposited by sputtering. Chromium or aluminum is preferably used as this metal. On it, photosensitive resist is coated. By pattern light exposure using a light exposure mask and development process, the metal thin-film is exposed except the portion, which is to be turned to the gate electrode. In this case, the portion to be turned to the gate line is also left untouched. By performing the etching on the metal thin-film exposed from the photosensitive resist, all portions except the area of the gate electrode (and the gate line) is dissolved. Then, the photosensitive resist is removed off and rinsed, and the gate electrode (and the gate line) are prepared.

### (2) Island forming process

First, after the gate has been prepared, a gate insulator film, a silicon semiconductor layer, and an n⁺ silicon layer, which is to be turned to a contact layer, are deposited in this order by CVD method (3-layer CVD method). On it, photosensitive resist is coated by photolithographic process including light exposure using light exposure mask and development process, and an island pattern of resist is prepared. After etching and removing-off of resist and rinsing, the island as desired is formed.

### (3) Source-drain electrode forming process (S-D forming process)

A metal for forming the source electrode and the drain electrode is sputtered to prepare a metal thin-film. By the same photolithographic process as described above, S-D electrode pattern of resist is formed. By etching process, the source electrode and the drain electrode are prepared. In this case, S-D gap on the channel region of the thin-film transistor, i.e. the gap between the opposed ends of the source electrode and the drain electrode, is formed by etching. Then, the resist is removed off and is rinsed.

### (4) Interlayer insulator film forming process

On the entire region including the source-drain electrodes, the interlayer insulator film is formed. By photolithographic process, the resist on the hole portion (contact hole portion) to connect the pixel electrode to one of the source-drain electrodes is removed, and a contact hole is formed by etching.

### (5) Pixel electrode forming process

On the interlayer insulator film where the contact hole has been formed, a transparent conductive film preferably made of ITO is sputtered, and a transparent conductive film is deposited. The transparent conductive film is connected to one of the source electrode and the drain electrode of the thin-film transistor via the contact hole. The photosensitive resist is coated to cover the transparent conductive film, and patterning is performed by photolithographic process, thereby leaving the pixel electrode intact. The exposed transparent conductive film is removed by etching, and the remaining resist is removed. By rinsing, the pixel electrode is prepared.

Then, the orientation film is coated, and by giving an ability to control liquid crystal orientation to it, the first panel PNL1 as explained in connection with Fig. 8 is completed. A second panel comprising a color filter and a counter electrode is superimposed on this first panel. By sealing a liquid crystal into the gap, a liquid crystal display panel is prepared.

Next, description will be given on a process to introduce the ink jet direct drawing method on the lines and the electrodes of the thin-film transistor as shown in the lower portion of Fig. 10. In the processes shown in the lower portion of Fig. 10, the ink jet direct drawing method is adopted instead of (1) "gate electrode forming process" as given above, and the gate electrodes and the gate lines are formed directly on the thin-film transistor substrate. Also, in (3) "source-drain electrode forming process (S-D forming process)", a metal to be turned to the source electrode and the drain electrode is formed by the ink jet direct drawing method. By performing the etching on this metal film, a gap is formed on channel region of the island between the source electrode and the drain electrode. The subsequent process is the same as the process shown in the upper portion of Fig. 10.

The Patent Document 1 discloses the formation of the lines and the like of the thin-film transistor substrate by the ink jet method. In the Patent Document 1, the gate electrode of the thin-film transistor TFT is prepared by the ink jet method using a liquid containing an electroconductive material. Also, it is described that the source electrode and the drain electrode of the thin-film transistor TFT is prepared by the ink jet method using a liquid containing a semiconductor material. The Patent Document 2 discloses the preparation of lyophilic pattern by performing light exposure on an optical catalyst layer. The Patent Document 3 is an example of the reference to disclose mask-less light exposure as to be described later.
[Patent Document 1] JP-A-2003-318193
[Patent Document 2] JP-A-2000-249821
[Patent Document 3] JP-A-2002-520840

US-B-6956236 discloses a liquid crystal display panel in which there is a liquid crystal layer between two substrates, one of which has a thin film transistor and the other has a color filter and counter electrode. The thin film transistor has gate and drain electrodes extending to the active layer from respective gate and drain links. The source and drain electrodes are formed by a laminated layer of a conductive layer and a transparent conductive layer.

When the thin-film transistor is prepared on the thin-film transistor substrate, the patterning process to prepare the gate electrodes or the source-drain electrodes is repeatedly performed. This consists of a metal sputtering process, resist coating and photolithographic process, etching process and removing off and rinsing of resist. However, it is difficult to reduce the number of the manufacturing facilities or to extensively reduce the cost of the processing by the repeating of such processes.

By adopting the ink jet direct drawing method instead of the processes as given above, it is possible to simplify the process to form the thin-film transistor and to realize the reduction of the number of the manufacturing facilities and the extensive improvement in production efficiency, and much expectation is now placed on the cost reduction in the process to manufacture the liquid crystal display system. Even when the gap between the source electrode and the drain electrode is prepared by combination of the ink jet direct drawing method and the pattern etching, the photolithographic process is still required, and this causes an obstacle to the reduction of the cost.

The ink jet direct drawing method may be adopted to form the gap by directly separating the source-drain electrodes without using the photolithographic method. Although the thin-film transistor can be prepared in easier manner by the adoption of ink jet direct drawing method, it is difficult in the patterning process by the ink jet direct drawing method to prepare a pattern with a narrow width of 30 µm or less. With the increase of high precision liquid crystal display system, it is now necessary to produce the thin-film transistor with higher precision. The manufacture of the thin-film transistor with higher precision means the necessity to have the narrowing of the channel potion, i.e. a narrower gap between the opposed ends of the source electrode and the drain electrode.

For the preparation of the gate lines and the gate electrodes using the ink jet method, the so-called lyophobic-lyophilic contrast pattern method is also proposed instead of IJ direct drawing method. In this lyophobic-lyophilic contrast pattern method, a gate line forming area and a gate electrode forming area on the substrate are turned to lyophilic pattern, and other portion is turned to lyophobic, and an electroconductive ink is dropped and poured to the lyophilic gate line forming area and to the lyophilic gate electrode forming area by IJ method (see the Patent Document 2 as given above). A combination method is also known, in which an optical catalyst is coated and lyophilic portion is provided by mask-less light exposure using micro-mirror and this is combined with IJ coating (see the Patent Document 3 as given above).

However, when the lyophobic-lyophilic contrast pattern method is applied, if there are portions with different widths in the lyophilic pattern, the electroconductive ink may not be poured to the forward end of the pattern with narrow width, or film thickness of the pattern with narrow width may become thinner. Also, in the method using a bank, photolithographic process for the formation of the bank and the process for preparing the lyophobic-lyophilic pattern are needed, and it is difficult to reduce the number of processes.

It is an object of the present invention to provide a liquid crystal display panel and a method for manufacturing the same, by which it is possible to narrow down the gap between the source electrode and the drain electrode to 4 µm or less without increasing the number of processes by using the ink jet direct drawing on the electrodes and the lines on the thin-film transistor.

According to a first aspect of the invention there is provided a liquid crystal display panel as defined in claim 1.
According to a second aspect of the invention there is provided a method for manufacturing a liquid crystal display panel as defined in claim 3.

According to the present invention, it is possible to extensively reduce the number of processes required for the formation of the thin-film transistor to be used in the liquid crystal display panel and to manufacture a liquid crystal display panel with very fine quality at lower cost.

In the drawings
Fig. 1 is a process chart to explain essential portion of a process for manufacturing a first substrate (thin-film transistor substrate), which constitutes a liquid crystal display panel of the present invention;
Fig. 2 represents drawings to explain a process for manufacturing the thin-film transistor of Embodiment 1 of the liquid crystal display panel of the present invention in concrete details;
Fig. 3 represents drawings continued from Fig. 2 to explain a process for manufacturing the thin-film transistor of Embodiment 1 of the liquid crystal display panel of the present invention in concrete details;
Fig. 4 represents drawings continued from Fig. 3 to explain a process for manufacturing the thin-film transistor of Embodiment 1 of the liquid crystal display panel of the present invention in concrete details;
Fig. 5 represents drawings continued from Fig. 4 to explain a process for manufacturing the thin-film transistor of Embodiment 1 of the liquid crystal display panel of the present invention in concrete details;
Fig. 6 represents drawings continued from Fig. 5 to explain a process for manufacturing the thin-film transistor of Embodiment 1 of the liquid crystal display panel of the present invention in concrete details;
Fig. 7 represents diagrams to explain equivalent circuit of an active matrix type liquid crystal display system;
Fig. 8 is a schematical cross-sectional view to explain an example of approximate arrangement of a typical longitudinal electric field type (the so-called TN type) liquid crystal display system;
Fig. 9 represents schematical drawings to explain an arrangement of a pixel of the liquid crystal display panel explained in Fig. 8 and an arrangement of the thin-film transistor to make up the pixel; and
Fig. 10 represents process charts to compare number of processes in the conventional photolithographic method and an ink jet direct drawing method to manufacture gate electrodes and source-drain electrodes in essential portion of a process for manufacturing thin-film transistor of a first panel PNL1.

Detailed description will be given below on an embodiment of the invention referring to the attached drawings.

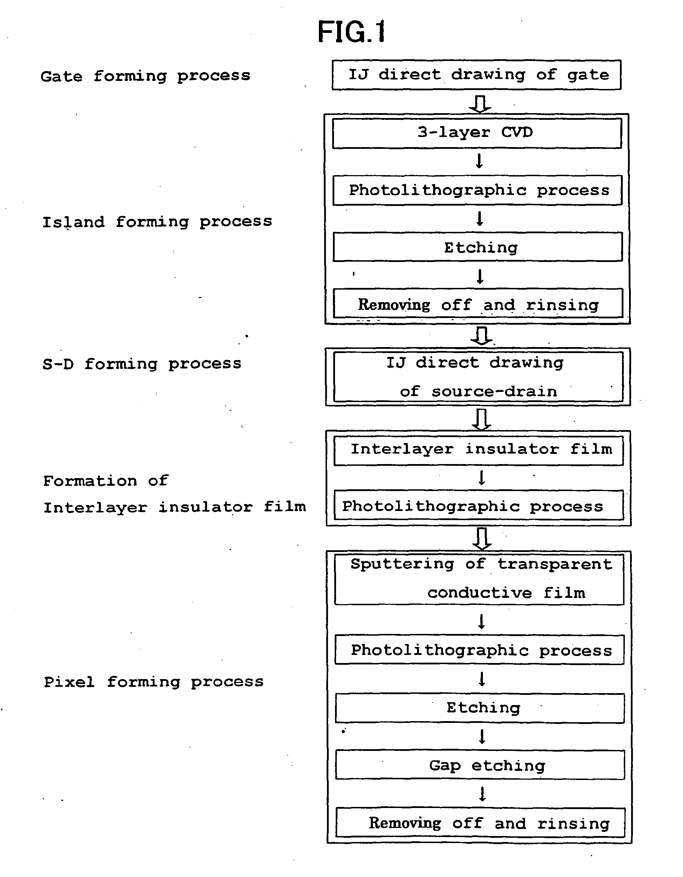

Fig. 1 is a process chart to explain an essential portion of a process for manufacturing a first substrate (a thin-film transistor substrate) to be used in a liquid crystal display panel of the present invention. First, a gate electrode and a gate line are prepared by direct drawing of ink jet on inner surface (above an underlying film) of a first substrate (thin-film transistor substrate), which is preferably made of a glass substrate. The direct drawing of the gate electrode and the gate line is the same as the gate direct drawing process as explained the lower portion of Fig. 10.

In the island forming process, after the formation of the gate, a gate insulator film, a silicon semiconductor layer, and an n⁺ silicon layer, which is to be turned to a contact layer, are deposited in this order by CVD method (3-layer CVD method). A photosensitive resist is coated on this silicon layer, and an island pattern of the resist is prepared by photolithographic process including the light exposure using a light exposure mask and development process. Then, etching is performed, and an island as required is prepared after removing off the photoresist and rinsing.

In the source-drain electrode forming process (S-D forming process), an electroconductive ink for forming the source-drain electrodes is applied by direct drawing of ink jet, thereby leaving a gap between the opposed ends of the source electrode and the drain electrode, and a channel is prepared in the island.

In the process for forming the interlayer insulator film, an interlayer insulator film is formed on the entire region on the substrate including the source-drain electrodes. By photolithographic process, at least the channel region including the opposed ends of the source electrode and the drain electrode is exposed.

In the pixel forming process, a transparent conductive film TCF preferably made of ITO is formed first by sputtering to cover the exposed channel region and the interlayer insulator film. A photoresist is coated on the sputtered transparent conductive film TCF. The resist of the channel region is removed by the photolithographic process. A gap is prepared, which is narrower than the gap between the opposed ends of the source electrode and the drain electrode formed by direct drawing of ink jet. In this case, the photoresist is also removed on free ends of the data line, the gate line, and the gate electrode so that the pixel electrode can be separated from the data line and the gate line.

On the portion where the photoresist has been removed a transparent conductive film TCF is prepared by etching. Then, the remaining photoresist is removed off and rinsed. Gap etching is performed on channel region. Thus, an opposed structure of the source electrode and the drain electrode of the transparent conductive film TCF, positioned opposite to each other with a narrow gap, is formed. In this case, the pixel electrode connected to the source electrode is also prepared. Then, an orientation film is deposited, and after rubbing process, the thin-film transistor substrate is completely formed.

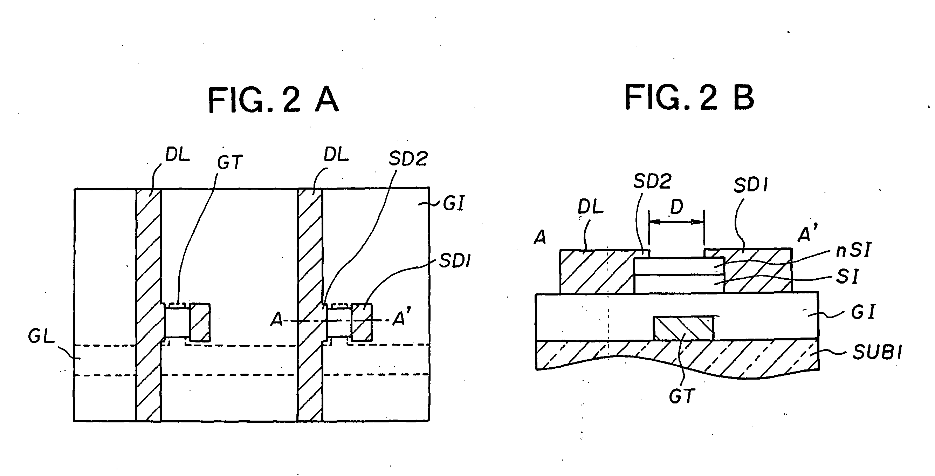

Fig. 2 to Fig. 6 each represents drawings to explain a process for manufacturing the thin-film transistor as described above in concrete details. Fig. 2 (a) to Fig. 4 (a) each represents a plan view, and Fig. 2 (b) to Fig. 4 (b) each represents a cross-sectional view of an essential portion along a dotted line. First, as shown in Fig. 2, a gate insulator film GI is formed on a gate line GL and a gate electrode GT, which have been prepared on inner surface of a glass substrate SUB1 (i.e. a first substrate) by the ink jet method. On this gate insulator film GI, a silicon semiconductor layer SI and an n+ contact layer nSI are deposited, and the island to form an active layer of the thin-film transistor is prepared by photolithographic process.

On this active layer with the center on the channel region of the thin-film transistor, a conductive layer including a source electrode SD1 a data line DL, and a drain electrode SD2 is formed by direct drawing of ink jet. In this case, a gap (distance) D between the source electrode SD1 and the drain electrode SD2 is 10 µm or more, which is the limitation in the direct drawing of ink jet. The source electrode and the drain electrode may be switched over to each other, while it is explained here as if these are fixed as shown in the drawings.

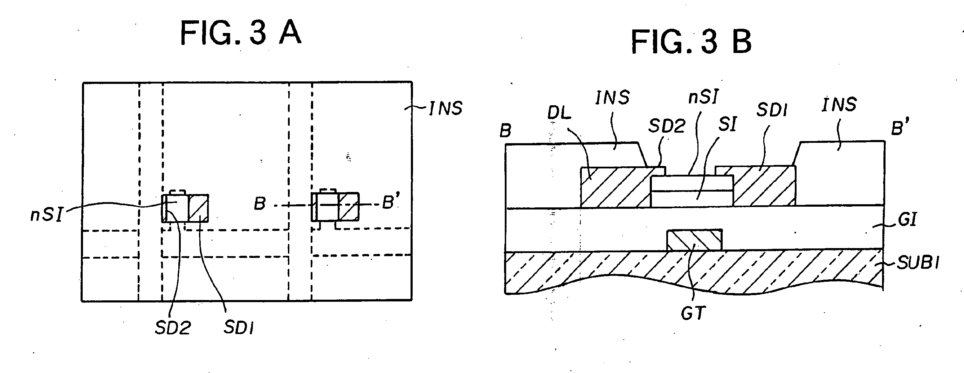

As shown in Fig. 3, an interlayer insulator film INS is deposited to cover a conductive layer, which is to be turned to the source electrode SD1, the data line DL, and the drain electrode SD2. The interlayer insulator film INS on the channel region formed on the opposed portions of the source electrode SD1 and the drain electrode SD2 is removed by photolithographic process, and the conductive end portion, which is to be turned to the source electrode SD1 and the drain electrode SD2 as well as the n⁺ contact layer nSI, are exposed.

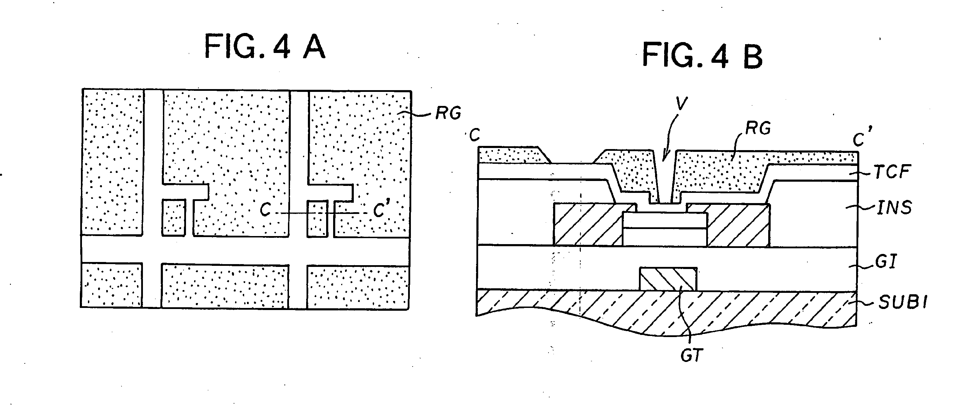

The transparent conductive film TCF preferably made of ITO is formed by sputtering on the entire region of the substrate including the conductive end portion, which is to be turned to the source electrode SD1 and the drain electrode SD2, and the exposed portion of the n⁺ contact layer nSI, and a photoresist RG is coated on it. The photoresist on the channel region is removed by the photolithographic process, and a groove V is formed on this photoresist RG. The groove V has a gap narrower than the gap between the opposed ends of the source electrode and the drain electrode prepared by direct drawing of ink jet. In this case, on the photoresist RG, a light exposure mask with a pattern is used to remove free end portions of the data line, the gate line and the gate electrode so that the pixel electrode is separated from the data line and the gate line (see Fig. 4).

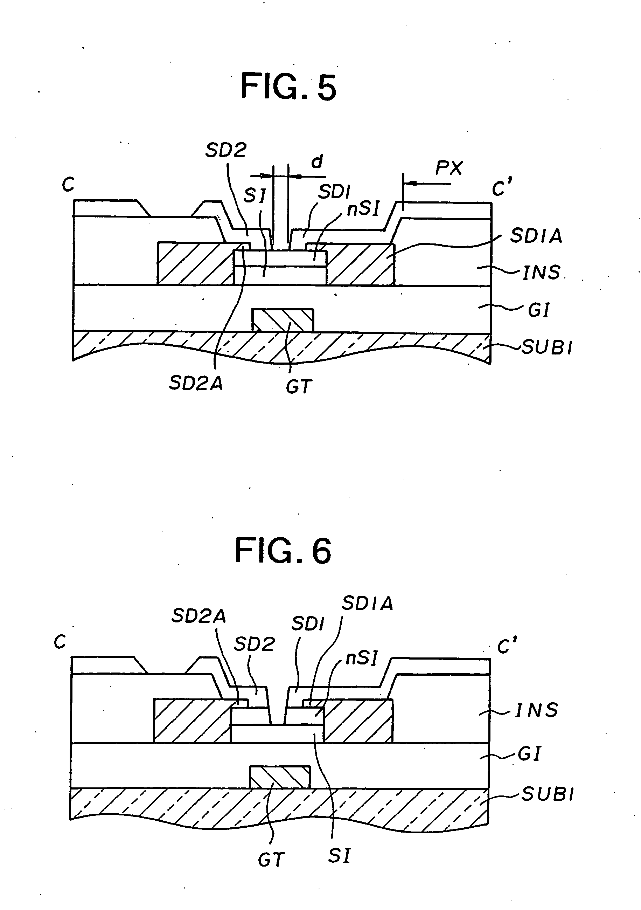

The transparent conductive film TCF on the portion where the photoresist RG has been removed is prepared by etching. Then, as shown in Fig. 5, the remaining photoresist is removed off and rinsed, and the transparent conductive film is exposed. On a portion connected to the transparent conductive film laminated on the source electrode layer SD1, the pixel electrode PX is prepared. Then, gap etching is performed on the transparent conductive film on the channel region. And an opposed structure of the source electrode SD1 and the drain electrode SD2 of the transparent conductive film TCF is obtained, which is opposed to each other with a gap "d" smaller than the gap "D" between the opposed ends of the source electrode SD1A and the drain electrode SD2A prepared by direct drawing of ink jet.

Then, as shown in Fig. 6, the n⁺ contact layer nSI is processed by etching, and a channel is formed on the underlying silicon semiconductor layer SI. Further, the orientation film is deposited and rubbing process is performed, and the thin-film transistor substrate is prepared. A color filter substrate (not shown) is attached on the thin-film transistor substrate. After a liquid crystal is sealed in it, a liquid crystal display panel is prepared. A driving circuit, a backlight and other structural members are combined with the liquid crystal display panel, and a liquid crystal display system is completed.

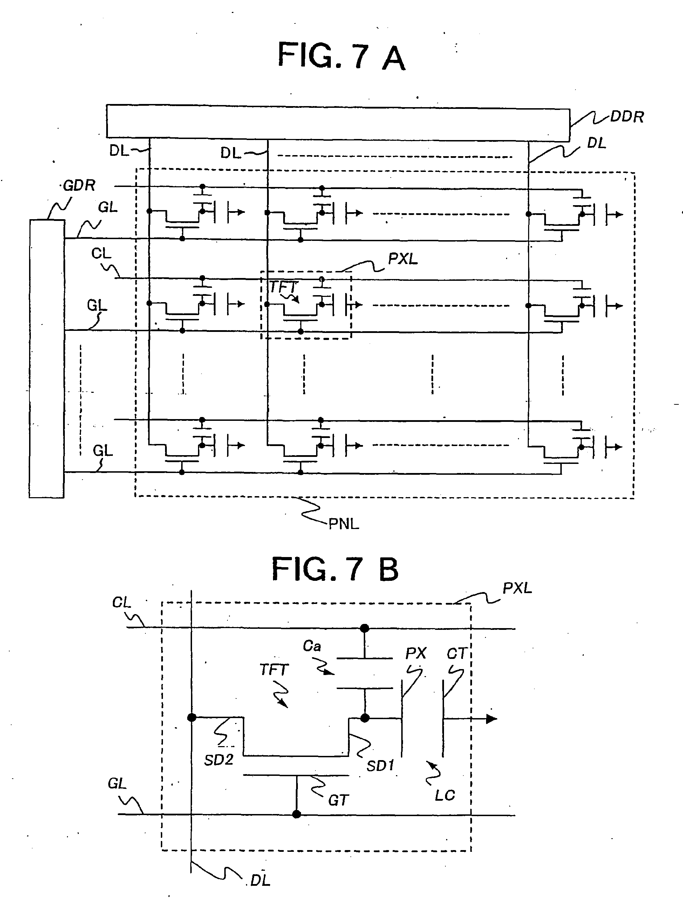

Fig. 7 represents diagrams to explain equivalent circuit of an active matrix type liquid crystal display system. Fig. 7 (a) is a circuit diagram of the entire liquid crystal display panel, and Fig. 7 (b) is an enlarged view of a pixel portion PXL shown in Fig. 7 (a). In Fig. 7 (a), a multiple of pixel portions PXLs are arranged in matrix form on the display panel PNL. Each pixel portion PXL is selected by a gate line driving circuit GDR and it is turned on according to a display data signal sent from a data line (also called source line) driving circuit DDR.

Specifically, to match the gate line GL selected by the gate line driving circuit GDR, a display data (voltage) is supplied to the thin-film transistor TFT on the pixel portion PXL of the liquid crystal display panel PNL via the data line DL from the data line driving circuit DDR.

As shown in Fig. 7 (b), the thin-film transistor TFT to make up the pixel portion PXL is provided at an intersection of the gate line GL and the data line DL. The gate electrode GT of the thin film transistor TFT is connected to the gate line GL, and the data line DL is connected to the drain electrode or the source electrode (drain electrode in this case) SD2 of the thin-film transistor TFT.

The drain electrode or the source electrode (source electrode in this case) SD1 of the thin-film transistor TFT is connected to the pixel electrode PX of the liquid crystal (element) LC. The liquid crystal LC is positioned between the pixel electrode PX and the common electrode CT and is driven by the data (voltage) supplied to the pixel electrode PX. An auxiliary capacity Ca to temporarily maintain the data is connected between the drain electrode SD2 and an auxiliary capacity line CL.

The drain electrode or the source electrode as shown in Fig. 7 is prepared in the embodiment of the present invention as described above.

## Claims

1. A liquid crystal display panel, comprising a first substrate (SUB1) on which a thin-film transistor (TFT) is formed, said thin-film transistor (TFT) having an active layer (SI, nSI) a gate electrode (GT) extending from a gate line (GL) to a region of the active layer, a drain electrode (SD2, SD2A) extending from a data line (DL) to a region of the active layer, and a source electrode (SD1, SD1A), a second substrate (SUB2) on which a color filter layer (CF) and a counter electrode (CT) are formed, and a liquid crystal layer (LC) sealed between a first orientation film (ORI 1) deposited on the uppermost layer on the inner surface of said first substrate (SUB 1) and a second orientation film (ORI 2) deposited on the uppermost layer on the inner surface of said second substrate (SUB2), wherein the active layer is formed on a gate insulator film (GI) formed on said first substrate (SUB 1) and covering said gate line(GL) and said gate electrode (GT), wherein both the source electrode and the drain electrode comprise a laminated layer includeing a conductive layer and a transparent conductive layer (TCF); each transparent conductive layer partially covering an upper layer of said active layer and the corresponding one of the facing ends of the conductive layers, wherein the conductive layers are arranged at opposed position with a first gap (D) therebetween and the transparent conductive layers are arranged at opposed position with a second gap (d) there between, **characterized in that:**
said first gap (D) is 10 µm or more in width, and said second gap (d) is 4 µm or less in width.

2. A liquid crystal display panel according to claim 1,
wherein:
each of said conductive layers to constitute said source electrode and said drain electrode arranged with said first gap (D) is formed by direct drawing of ink jet of an electroconductive ink containing fine metal particles; and
said transparent conductive film (TCF) comprises a sputtered film of an electroconductive metal oxide, and said second gap (d) is formed by etching of said sputtered film.

3. A method of manufacturing a liquid crystal display panel, said liquid crystal display panel comprising a first substrate (SUB 1) on which a thin-film transistor (TFT) is formed, said thin-film transistor having an active layer (SI, nSI), a gate electrode (GT) extending from a gate line (GL) to a region of the active layer, a drain electrode (SD2, SD2A) extending from a data line (DL) to a region of the active layer, and a source electrode (SD1, SD1A), a second substrate (SUB 2) on which a color filter layer (CF) and a counter electrode (CT) are formed, and a liquid crystal layer (LC) sealed between a first orientation film (ORI 1) deposited on the uppermost layer on the inner surface of said first substrate (SUB 1) and a second orientation film (ORI 2) deposited on the uppermost layer on the inner surface of said second substrate (SUB 2),
said method comprising the steps of:
preparing a semiconductor island by patterning on a gate insulator film (GI) formed on said first substrate (SUB 1) to cover the gate line (GL) and the gate electrode (GT) ;
turning said semiconductor island to an active layer; forming laminated layers of conductive layers and transparent conductive layers (TCF) as a source electrode and a drain electrode by forming conductive layers arranged at opposed position with a first gap (D) therebetween by direct drawing of ink jet, to turn said active layer to a channel, and
by forming a transparent conductive film by sputtering, the film to cover the conductive layers and the active layer ; and forming a second gap (d) by etching the transparent conductive film between opposed ends of the conductive layers, wherein:
said first gap (D) formed by direct drawing of ink jet is set to 10 µm or more in width, and said second gap (d) formed by said etching is set to 4 µm or less in width.

4. A method of manufacturing a liquid crystal display panel according to claim 3, wherein said method further comprises the step of forming said data line (DL) by direct drawing of ink jet.

5. A method of manufacturing a liquid crystal display panel according to claim 3 or claim 4, wherein said method further comprises the step of forming said gate line (GL) and said gate electrode (GT) by lyophobic-lyophilic contrast patterning and direct drawing or dropping of ink jet.

6. A method of manufacturing a liquid crystal display panel according to claim 5, wherein:
said method further comprises the step of forming said gate line (GL) by direct drawing of ink jet and of forming said gate electrode (GT) by dropping of ink jet.

## Patentansprüche

1. Flüssigkristallanzeigefeld, das Folgendes umfasst: ein erstes Substrat (SUB1), auf dem ein Dünnschichttransistor (TFT) ausgebildet ist, wobei der Dünnschichttransistor (TFT) eine aktive Schicht (SI, nSI), eine Gate-Elektrode (GT), die sich von einer Gate-Leitung (GL) zu einem Bereich der aktiven Schicht erstreckt, eine Drain-Elektrode (SD2, SD2A), die sich von einer Datenleitung (DL) zu einem Bereich der aktiven Schicht erstreckt, und eine Source-Elektrode (SD1, SD1A) aufweist, ein zweites Substrat (SUB2), auf dem eine Farbfilterschicht (CF) und eine Gegenelektrode (CT) ausgebildet sind; sowie eine Flüssigkristallschicht (LC), die zwischen einer ersten Ausrichtungsschicht (ORI 1), die auf der obersten Schicht an der Innenoberfläche des ersten Substrats (SUB1) abgeschieden ist, und einer zweiten Ausrichtungsschicht (ORI 2), die auf der obersten Schicht an der Innenoberfläche des zweiten Substrats (SUB2) eingeschlossen ist, wobei die aktive Schicht auf einer Gate-Isolationsschicht (GI) ausgebildet ist, die auf dem ersten Substrat (SUB1) ausgebildet ist und die Gate-Leitung (GL) und die Gate-Elektrode (GT) bedeckt, wobei
sowohl die Source-Elektrode als auch die Drain-Elektrode eine laminierte Schicht umfassen, die eine leitfähige Schicht und eine transparente leitfähige Schicht (TCF) umfasst, wobei jede transparente leitfähige Schicht teilweise eine obere Schicht der aktiven Schicht und die entsprechenden gegenüberliegenden Enden der leitfähigen Schichten bedeckt, wobei die leitfähigen Schichten mit einem ersten Spalt (D) an einer gegenüberliegenden Position zwischen diesen angeordnet sind und die transparenten leitfähigen Schichten mit einem zweiten Spalt (d) an einer gegenüberliegenden Position zwischen diesen angeordnet sind,
**dadurch gekennzeichnet, dass** der erste Spalt (D) eine Breite von 10 µm oder mehr aufweist und der zweite Spalt (d) eine Breite von 4 µm oder weniger aufweist.

2. Flüssigkristallanzeigefeld nach Anspruch 1, worin:
jede der leitfähigen Schichten, die die Source-Elektrode und die Drain-Elektrode bilden und mit dem ersten Spalt (D) angeordnet sind, durch das direkte Aufbringen elektrisch leitfähiger Tinte, die feine Metallteilchen enthält, durch einen Tintenstrahl ausgebildet wird; und
die transparente leitfähige Schicht (TCF) eine Zerstäubungsschicht eines elektrisch leitfähigen Metalloxids umfasst und der zweite Spalt (d) durch das Ätzen der Zerstäubungsschicht ausgebildet ist.

3. Verfahren zur Herstellung eines Flüssigkristallanzeigefelds, wobei das Flüssigkristallanzeigefeld Folgendes umfasst: ein erstes Substrat (SUB1), auf dem ein Dünnschichttransistor (TFT) ausgebildet ist, wobei der Dünnschichttransistor (TFT) eine aktive Schicht (SI, nSI), eine Gate-Elektrode (GT), die sich von einer Gate-Leitung (GL) zu einem Bereich der aktiven Schicht erstreckt, eine Drain-Elektrode (SD2, SD2A), die sich von einer Datenleitung (DL) zu einem Bereich der aktiven Schicht erstreckt, und eine Source-Elektrode (SD1, SD1A) aufweist; ein zweites Substrat (SUB2), auf dem eine Farbfilterschicht (CF) und eine Gegenelektrode (CT) ausgebildet sind; sowie eine Flüssigkristallschicht (LC), die zwischen einer ersten Ausrichtungsschicht (ORI 1), die auf der obersten Schicht der Innenoberfläche des ersten Substrats (SUB1) abgeschieden ist, und der obersten Schicht an der Innenoberfläche des zweiten Substrats (SUB2) eingeschlossen ist, wobei das Verfahren folgende Schritte umfasst:
das Herstellen einer Halbleiterinsel durch das Ausbilden einer Struktur auf einer Gate-Isolationsschicht (GI), die auf dem ersten Substrat (SUB1) ausgebildet ist, um die Gate-Leitung (GL) und die Gate-Elektrode (GT) zu bedecken;
das Umwandeln der Halbleiterinsel in eine aktive Schicht;
das Ausbilden von laminierten Schichten aus leitfähigen Schichten und transparenten leitfähigen Schichten (TCF) als Source-Elektrode und einer Drain-Elektrode durch das Ausbilden von leitfähigen Schichten, die an entgegengesetzten Positionen mit einem ersten Spalt (D) zwischen diesen angeordnet sind, durch das direkte Aufbringen eines Tintenstrahls, um die aktive Schicht in einen Kanal umzuwandeln, und durch das Ausbilden einer transparente leitfähige Schicht durch das Zerstäuben der Schicht, um die leitfähigen Schichten und die aktive Schicht zu Bedecken;
und das Ausbilden eines zweiten Spalts (d) durch das Ätzen der transparenten leitfähigen Schicht zwischen den entgegengesetzten Enden der leitfähigen Schichten, wobei:
der erste Spalt (D), der durch das direkte Aufbringen eines Tintenstrahls ausgebildet wird, eine Breite von 10 µm oder mehr aufweist, und der zweite Spalt (d), der durch das Ätzen ausgebildet wird, eine Breite von 4 µm oder weniger aufweist.

4. Verfahren zur Herstellung eines Flüssigkristallanzeigefelds nach Anspruch 3, wobei das Verfahren ferner den Schritt des Ausbildens der Datenleitung (DL) durch das direkte Aufbringen eines Tintenstrahls umfasst.

5. Verfahren zur Herstellung eines Flüssigkristallanzeigefelds nach Anspruch 3 oder 4, wobei das Verfahren ferner den Schritt des Ausbildens der Gate-Leitung (GL) und der Gate-Elektrode (GT) durch das Ausbilden einer Struktur durch lyophobenlyophilen Kontrast und das direkte Aufbringen oder Auftropfen eines Tintenstrahls.

6. Verfahren zur Herstellung eines Flüssigkristallanzeigefelds nach Anspruch 5, wobei:
das Verfahren ferner den Schritt des Ausbildens der Gate-Leitung (GL) durch das direkte Aufbringen eines Tintenstrahls und des Ausbildens der Gate-Elektrode (GT) durch das Auftropfen eines Tintenstrahls umfasst.

## Revendications

1. Panneau d'affichage à cristaux liquides, comprenant:
un premier substrat (SUB1) sur lequel un transistor à couches minces (TFT) est formé, ledit transistor à couches minces (TFT) comportant une couche active (SI, nSI), une électrode de grille (GT) s'étendant d'une ligne de grille (GL) vers une région de la couche active, une électrode de drain (SD2, SD2A) s'étendant d'une ligne de données (DL) vers une région de la couche active, et une électrode de source (SD1, SD1A),
un deuxième substrat (SUB2) sur lequel une couche de filtre coloré (CF) et une contre-électrode (CT) sont formées, et une couche de cristal liquide (LC) enfermée hermétiquement entre un premier film d'orientation (ORI 1) déposé sur la couche supérieure sur la surface interne dudit premier substrat (SUB1) et un deuxième film d'orientation (ORI 2) déposé sur la couche supérieure de la surface interne dudit deuxième substrat (SUB2),
dans lequel
la couche active est formée sur un film isolant de grille (GI) formé sur ledit premier substrat (SUB1) et recouvrant ladite ligne de grille (GL) et ladite électrode de grille (GT),
dans lequel
l'électrode de source et l'électrode de drain comprennent toutes deux une couche stratifiée comprenant une couche conductrice et une couche conductrice transparente (TCF), chaque couche conductrice transparente recouvrant partiellement une couche supérieure de ladite couche active et l'extrémité correspondante parmi les extrémités en regard des couches conductrices,
dans lequel
les couches conductrices sont agencées à des positions opposées avec un premier espace (D) entre elles et les couches conductrices transparentes sont agencées à des positions opposées avec un deuxième espace (d) entre elles,
**caractérisé en ce que**
ledit premier espace (D) a une largeur de 10 µm ou plus, et ledit deuxième espace (d) a une largeur de 4 µm ou moins.

2. Panneau d'affichage à cristaux liquides selon la revendication 1, dans lequel:
chacune desdites couches conductrices pour constituer ladite électrode de source et ladite électrode de drain agencées avec ledit premier espace (D) est formée en traçant directement un jet d'encre d'une encre électroconductrice contenant de fines particules métalliques; et
ledit film conducteur transparent (TCF) comprend un film pulvérisé d'un oxyde métallique électroconducteur, et ledit deuxième espace (d) est formé en gravant ledit film pulvérisé.

3. Procédé de fabrication d'un panneau d'affichage à cristaux liquides, ledit panneau d'affichage à cristaux liquides comprenant un premier substrat (SUB1) sur lequel un transistor à couches minces (TFT) est formé, ledit transistor à couches minces comportant une couche active (SI, nSI), une électrode de grille (GT) s'étendant d'une ligne de grille (GL) vers une région de la couche active, une électrode de drain (SD2, SD2A) s'étendant d'une ligne de données (DL) vers une région de la couche active, et une électrode de source (SD1, SD1A), un deuxième substrat (SUB2) sur lequel une couche de filtre coloré (CF) et une contre-électrode (CT) sont formées, et une couche de cristal liquide (LC) enfermée hermétiquement entre un premier film d'orientation (ORI 1) déposé sur la couche supérieure sur la surface interne dudit premier substrat (SUB1) et un deuxième film d'orientation (ORI 2) déposé sur la couche supérieure de la surface interne dudit deuxième substrat (SUB2),
ledit procédé comprenant les étapes consistant à:
préparer un îlot semi-conducteur en dessinant sur un film isolant de grille (GI) formé sur ledit premier substrat (SUB1) pour recouvrir la ligne de grille (GL) et l'électrode de grille (GT);
transformer ledit îlot semi-conducteur en une couche active;
former des couches stratifiées de couches conductrices et de couches conductrices transparentes (TCF) en tant qu'électrode de source et électrode de drain en formant des couches conductrices agencées à des positions opposées avec un premier espace (D) entre elles en traçant directement un jet d'encre pour transformer ladite couche active en un canal, et en formant un film conducteur transparent par pulvérisation, le film pour recouvrir les couches conductrices et la couche active; et
former un deuxième espace (d) en gravant le film conducteur transparent entre les extrémités opposées des couches conductrices, dans lequel:
ledit premier espace (D) formé en traçant directement un jet d'encre est fixé à une largeur de 10 µm ou plus, et ledit deuxième espace (d) formé par ladite gravure est fixé à une largeur de 4 µm ou moins.

4. Procédé de fabrication d'un panneau d'affichage à cristaux liquides selon la revendication 3, dans lequel ledit procédé comprend en outre l'étape de formation de ladite ligne de données (DL) en traçant directement un jet d'encre.

5. Procédé de fabrication d'un panneau d'affichage à cristaux liquides sont la revendication 3 ou la revendication 4, dans lequel ledit procédé comprend en outre l'étape de formation de ladite ligne de grille (GL) et de ladite électrode de grille (GT) en dessinant par contraste lyophobe-lyophile et en traçant directement ou en lançant un jet d'encre.

6. Procédé de fabrication d'un panneau d'affichage à cristaux liquides selon la revendication 5, dans lequel:
ledit procédé comprend en outre l'étape de formation de ladite ligne de grille (GL) en traçant directement un jet d'encre et de formation de ladite électrode de grille (GT) en lançant un jet d'encre.
